# EUROPEAN PATENT APPLICATION

(11) **EP 1 420 088 A1**
(43) Date of publication of application: **19.05.2004**
(21) Application number: 02755784.2
(22) Date of filing: 02.08.2002
(51) Int. Cl.: C30B 29/22, H01B 12/06

(54) **HIGH-TEMPERATURE SUPERCONDUCTIVE FILM HAVING FLAT SURFACE**

(30) Priority: 22.08.2001 JP 2001251133
(71) Applicant: International Superconductivity Technology Center, The Juridical Foundation, Tokyo 105-0004 (JP)
(72) Inventor: ADACHI, S. c/o Int. Superconductivity Tech. Center, Tokyo 135-0062 (JP); WAKANA, H. c/o Int. Superconductivity Tech. Center, Tokyo 135-0062 (JP); SUGANO, T. c/o Int. Superconductivity Tech. Center, Tokyo 135-0062 (JP); TANABE, K. c/o Int. Superconductivity Tech. Center, Tokyo 135-0062 (JP)
(74) Representative: Poulin, Gérard
(86) International application number: PCT/JP2002/007902
(87) International publication number: WO 2003/018883

(57) **Abstract**

A high temperature superconductor film having a smooth surface is constituted from A, B, C, Cu and oxygen in a composition that is represented by the chemical formula AₓB_{(3-x-y)}C_{y}Cu_{z}O_{7-d} (where x ≦ 0.99, y ≦ 1.99, 2.60 ≦ (x + y) ≦ 2.98, 2.70 ≦ z ≦ 3.30 and (7-d) is a value that satisfies the requirement of valence), when one or more element selected from the group of Gd, Dy, Ho, Er, Tm, Yb, Lu and Y is represented by A, one or more element selected from the group of La, Nd, Sm and Eu is represented by B and Ba₁₋ₛSrₛ (where 0 ≦ s ≦ 0.50) is represented by C.

## Description

### TECHNICAL FIELD

The present invention relates to a high temperature superconductor film manufactured by such process as sputtering or laser deposition, and particularly relates to a high temperature superconductor film having a smooth surface that is suitable for the manufacture of electronic devices, electric wires or the like.

### BACKGROUND ART

Much progress has recently been made in research on superconductors, which have unique properties such as zero electrical resistance, perfect diamagnetism, and Josephson effect, and development work is in progress for a wide range of applications of superconductors including transmission of electric power, generation of electric power, confinement of plasma for nuclear fusion, magnetically levitated vehicles, magnetic shields, and high-speed computers.

In 1986, Bednorz and Mueller discovered a copper oxide superconductor (La₁₋ ₓBaₓ)₂CuO₄ that has a superconducting transition temperature (Tc) as high as about 30K. Since then, successive reports have been made on materials that make the transition into a superconducting state at high temperatures such as YBa₂Cu₃O_{7-d} (Tc = 90K), Bi₂Sr₂Ca₂Cu₃O_{y} (Tc = 110K), Tl₂Ba₂Ca₂Cu₃O_{y} (Tc = 125K) and HgBa₂Ca₂Cu₃O_{y} (Tc = 135K). Accordingly, much research has been conducted and published on methods of manufacture, physical properties and applications of these materials. It is known that the most useful superconducting property can be obtained when the valence n of copper atom (Cuⁿ⁺) in the formula is within a range of 2.0 < n < 2.67, where each superconductor has a sufficient number of oxygen atoms to meet the requirement of the valence of copper.

Among these materials, YBa₂Cu₃O_{7-d} is a high temperature superconductor that does not include harmful substances such as Tl and Hg and has relatively low anisotropy, and is therefore viewed as one of the most promising candidates for the high temperature superconductor used as the material in practical manufacture of electronic devices, electric wires and the like.

The YBa₂Cu₃O_{7-d} superconductor is known to show superconducting transition temperature Tc of about 90K also when the component Y is replaced with a rare earth element (La, Nd, Sm, Eu, Gd, Dy, Ho, Er, Tm, Yb and/or Lu) (superconductors obtained through such substitution will be hereinafter collectively called 123 superconductors). In this case, melting temperature of the superconductor tends to become lower as the ionic radius of the substituting atom decreases.

When synthesizing such a 123 superconductor, the following precautions are required depending on the ionic radius of Y and the substituting rare earth element.

When synthesizing a 123 superconductor constituted from La, Nd, Sm and/or Eu, after promoting the orderly arrangement of atoms by high-temperature heat treatment (at about 900°C or higher) in an atmosphere having a low partial pressure of oxygen, annealing (at about 350°C) must be applied in flowing oxygen gas so as to absorb a sufficient amount of oxygen.

When synthesizing a 123 superconductor constituted from Gd, Dy, Ho, Er, Tm and/or Y, in contrast, a sufficient amount of oxygen can be absorbed and good superconductivity can be achieved only by firing the material in an oxygen gas flow and gradually cooling. Since the material of this constitution absorbs all oxygen required in a temperature range from 400 to 600°C during the cool-down period after firing, there is no need to apply annealing in an oxygen gas flow thereafter.

When the constituent elements include Yb or Lu, the 123 type crystal structure is stabilized in flowing oxygen gas at a temperature from 870 to 920°C. When the heat treatment temperature is higher than this range, the material melts. When the heat treatment temperature is below this range, on the other hand, a different phase is stabilized. Moreover, an arrangement must be provided to control the atmosphere, in order to obtain the material in a single phase.

In the case of 123 superconductor having a composition including Yb or Lu, similarly to the case of Y, a sufficient amount of oxygen is absorbed in a temperature range from 400 to 600°C and satisfactory superconductivity is obtained.

The 123 superconductor having a composition that includes Gd, Dy, Ho, Er, Tm, Yb, Lu and/or Y is thus viewed as a useful material in order to simplify the manufacturing process, since the temperatures at which oxygen is absorbed are from 400 to 600°C and a sufficient amount of oxygen can be absorbed and good superconductivity can be achieved without carrying out annealing in an oxygen atmosphere at a low temperature (about 350°C), only by gradually cooling in an oxygen gas flow when cooling down after firing.

In order to make practical use of the 123 superconductor having a composition including Gd, Dy, Ho, Er, Tm, Yb, Lu and/or Y, the material must be formed in an appropriate shape.

However, the 123 superconductor is an oxide that is inferior in plasticity and cannot be easily formed in a desired shape by plastic forming process. Therefore, various forming methods have been studied to achieve this, such as applying heat treatment to powdery material deposited on a substrate that is formed in a desired shape so as to turn the powdery material into the 123 superconductor, or forming the 123 superconductor densely on a substrate that is formed in a desired shape by chemical means, or growing a pseudo-single crystal film of the 123 superconductor by physical means.

However, practical application to electronic devices or electric wire that requires high reliability makes it necessary to manufacture the 123 superconductor while carrying out sophisticated control of the material by physical means such as sputtering or laser deposition, and therefore it would be indispensable to develop a proper film forming technology based on the former.

The sputtering and laser deposition processes are film forming methods wherein energy of a plasma or laser beam is applied to a target that is the stock material to make the film, and particles expelled from the target by the energy are caused to deposit on a substrate.

In this case, it is common to use a target made of a ceramic material having the same composition as that of the desired film. Conditions for making the desired film are found by repeatedly changing such factors as the ambient gas, substrate temperature, applied energy and the distance between the target and the substrate.

While there are many factors that determine the quality of the superconductor film formed by sputtering or laser deposition as described above, composition of the film material is especially important.

When the composition of cations in the product film deviates from the intended composition, the disparity in the composition results in a lattice defect in the crystal that constitutes the film, thereby straining the crystal. The strain not only appears on the surface in the form of bulge or dents resulting in impaired surface smoothness, but also disturbs the crystal orientation, thus adversely affecting the film properties.

Moreover, existence of the disparity in the composition described above also causes the excess component to precipitate on the film surface when forming the film, again impairing the surface smoothness of the film and resulting in degradation in the properties.

Lack of smoothness of the superconductor film has adverse effects on the performance of the product such as a device or electric wire.

In order to make practical use of the 123 superconductor having composition that includes Gd, Dy, Ho, Er, Tm, Yb, Lu and/or Y for electronic devices or electric wire, it is necessary to develop means of manufacturing the 123 superconductor film having a smooth surface with good reproducibility.

### DISCLOSURE OF THE INVENTION

With the background described above, an object of the present invention is to provide a means capable of manufacturing the 123 superconductor film having a smooth surface in a composition including Gd, Dy, Ho, Er, Tm, Yb, Lu and/or Y with good productivity without being affected by subtle changes in the film forming conditions.

Through research aimed at achieving the object described above, the inventors of the present application acquired the following findings a) to c).
a) When forming a 123 superconductor film based on Gd, Dy, Ho, Er, Tm, Yb, Lu and/or Y that is constituted from one or two elements selected from a group of Gd, Dy, Ho, Er, Tm, Yb, Lu and Y and other major components of Ba, Cu and oxygen, making such a composition of the film that includes one or more element selected from among a group of La, Nd, Sm and Eu to a certain extent in addition to the elements described above makes it possible to manufacture the 123 superconductor film having smooth surface and high quality reliably with good reproducibility, without losing such an advantage of the 123 superconductor film based on Gd, Dy, Ho, Er, Tm, Yb, Lu and/or Y that all the required oxygen is absorbed so as to achieve good superconducting characteristics without annealing in oxygen atmosphere at a low temperature (about 350°C), and without being affected by minor deviation in the composition of cations or subtle changes in the film forming conditions.
b) Up to about half the number of Ba atoms of the superconductor film can be replaced with Sr, without causing a significant change in the superconducting characteristics or in the film surface condition.
c) Composition of a superconductor film consisting of pure c-axis orientation film that is required of a practical superconductor film and is capable of achieving zero electric resistance at a temperature not lower than the liquid nitrogen temperature is represented by chemical formula AₓB_{(3-x-y)}C_{y}Cu_{z}O_{7-d} (where x ≦ 0.99, y ≦ 1.99, 2.60 ≦ (x + y) ≦ 2.98, 2.70 ≦ z ≦ 3.30 and (7-d) is a value that satisfies the requirement of valence), when one or more elements selected from the group of Gd, Dy, Ho, Er, Tm, Yb, Lu and Y is represented by A, one or more elements selected from the group of La, Nd, Sm and Eu is represented by B and Ba₁₋ₛSrₛ (where 0 ≦ s ≦ 0.50) is represented by C. Value of (7-d) varies depending not only on the values of x, y and z, but also on the valence of Cu. The valence of Cu should be in a range from 2.0 to 2.67 in order to achieve the most useful superconducting characteristics, as described above.

The present invention has been completed on the basis of the findings described above, and provides a high temperature superconductor film as described below.
(1) A high temperature superconductor film having a smooth surface constituted from A, B, C, Cu and oxygen and is represented by the chemical formula AₓB_{(3-x-y)}C_{y}Cu_{z}O_{7-d} (where x ≦ 0.99, y ≦ 1.99, 2.60 ≦ (x + y) ≦ 2.98, 2.70 ≦ z ≦ 3.30 and (7-d) is a value that satisfies the requirement of valence), when one or more elements selected from the group of Gd, Dy, Ho, Er, Tm, Yb, Lu and Y is represented by A, one or more elements selected from the group of La, Nd, Sm and Eu is represented by B and Ba₁₋ₛSrₛ (where 0 ≦ s ≦ 0.50) is represented by C.
(2) The high temperature superconductor film having a smooth surface as described in (1) wherein the number of precipitations, bumps, and dents having sizes that could not be contained within an area of 1 µm square is 10 or less that are observed in an area of 30 µm square on the surface of the high temperature superconductor film when observed under an optical microscope at a magnification of 1000 times.
(3) The high temperature superconducting film having a smooth surface as described in (1) wherein the number of precipitations, bumps and dents having sizes that could not be contained within an area of 1 µm square is 5 or less that are observed in an area of 30 µm square on the surface of the high temperature superconducting film when observed under an optical microscope at a magnification of 1000 times.

### BRIEF DESCRIPTION OF THE DRAWINGS

Fig. 1 is a schematic diagram showing the cation atom ratio in the high temperature superconductor film of the [Gd, Dy, Ho, Er, Tm, Yb, Lu, Y] - [La, Nd, Sm, Eu] - [Ba, Sr] - Cu system according to the present invention.
Fig. 2 is a schematic diagram showing the cation atom ratio in the superconductor of the [Gd, Dy, Ho, Er, Tm, Yb, Lu, Y]- [Ba, Sr] - Cu system.
Fig. 3 is a schematic diagram showing the cation atom ratio in the superconductor of [La, Nd, Sm, Eu] - [Ba, Sr] - Cu system.
Fig. 4 is an explanatory diagram of the range of compositions of the high temperature superconductor film according to the present invention.
Fig. 5A to Fig. 5C schematically show the surface conditions of thin films obtained in examples of the present invention observed under an optical microscope at a magnification of 1000 times.
Fig. 6 shows X-ray diffraction (XRD) pattern of a thin film obtained in "Reference Test" of Example 1.
Fig. 7 shows X-ray diffraction (XRD) pattern of a thin film obtained in "Example Test" of Example 1.
Fig. 8 shows a graph showing the result of resistivity measurement by direct current 4-terminal method that represents the temperature dependency of electric resistivity of a thin film obtained in "Example Test 1" of Example 1.

### BEST MODE FOR CARRYING OUT THE INVENTION

Now the present invention will be described below along with the operation thereof.

The 123 superconductor has a crystal structure based on a perovskite structure, wherein cations are located in an orderly arrangement according to the ionic radius thereof.

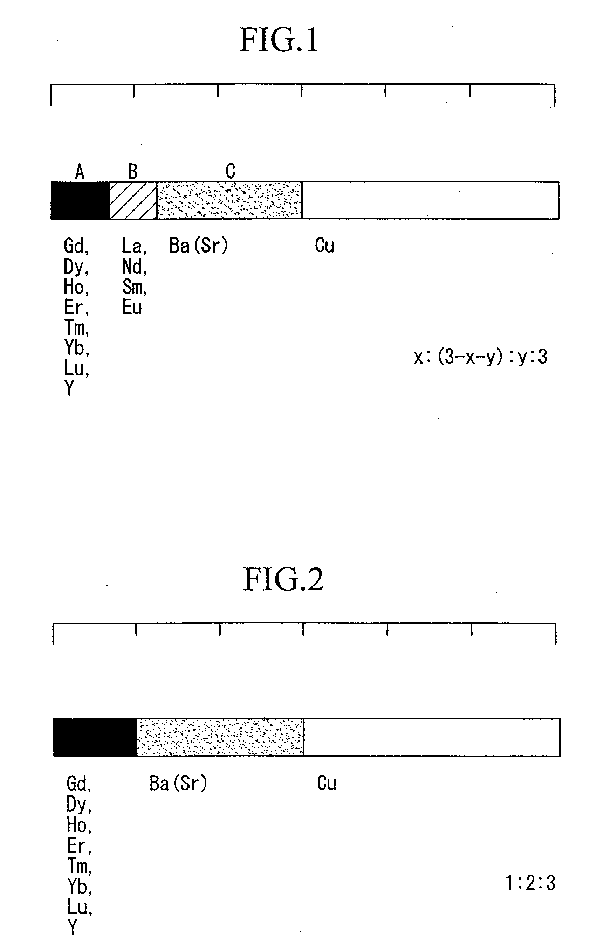

For example, 123 superconductor constituted from A, Ba (a part of which may be replaced with Sr), Cu and oxygen, wherein one or more element selected from a group of Gd, Dy, Ho, Er, Tm, Yb, Lu and Y is represented by A has cations of A, Ba and Cu located in an orderly arrangement. Since these cations have significant difference in the ionic radius from each other, they do not substitute at each other's atomic site. Therefore, proportions of the cations A: Ba: Cu must be 1:2:3 as shown in Fig. 2. Deviation of the proportions of cations from this ratio can easily generate a strain in the crystal lattice or impurity.

When strain in the crystal lattice or impurity is generated in the superconductor film, such defects causes deterioration in the surface smoothness that may directly or indirectly block the superconducting current. Thus generation of strain in the crystal lattice or impurity must be avoided when manufacturing electronic devices or electric wire.

For this reason, strict process control must be exercised when manufacturing a 123 superconductor film having a composition that includes Gd, Dy, Ho, Er, Tm, Yb, Lu and/or Y, so as to avoid deviation of the composition.

In the case of a 123 superconductor constituted from B, Ba (a part of which may be replaced with Sr), Cu and oxygen, wherein one or more element selected from a group of La, Nd, Sm and Eu is represented by B, in contrast, since there is a small difference in the ionic radius, it is known that the site of Ba can be partially substituted with B element. Moreover, this substitution does not cause significant reduction of the superconducting transition temperature Tc, if the amount of substitution is small.

In other words, the 123 superconductor based on B (La, Nd, Sm, Eu) does not require the proportions of cations A: Ba Cu to be 1:2:3 and maintains good superconductivity as long as the ratio (B + Ba):Cu is 1:1.

From this point of view, the 123 superconductor based on B (La, Nd, Sm, Eu) can be regarded as a material of which quality is not easily affected by the deviation of composition and can be easily manufactured.

However, in order to achieve good superconductivity with the 123 superconductor based on B (La, Nd, Sm, Eu), it is necessary to conduct annealing (at about 350°C) in flowing oxygen gas so as to absorb sufficient amount of oxygen after promoting the orderly arrangement of atoms by high-temperature heat treatment (at about 900°C or higher) in an atmosphere that includes oxygen of low partial pressure, as described previously, which increases the heat treatment processes.

This material also has such a problem in that an impurity immediately precipitates when deviation in the composition occurs with the proportion of atom B/Ba becoming less than 0.5 for some reason.

When the B element is added in a particular proportion as a constituent of the film when manufacturing the 123 superconductor film constituted mainly from A element, Ba, Cu and oxygen, however, since B is an element that can substitute both atomic sites of A and Ba in the 123 superconductor, a margin (tolerable region of deviation) is permitted in the composition of cations that can maintain good superconductivity as shown in Fig. 1, and some deviation in the composition of A, B and Ba can be accommodated without such problems as strain generated in the crystal lattice and precipitation of impurity that may deteriorate the surface smoothness of the superconductor.

It should be noted here that, as long as the amount of substitution with B is within the margin (tolerable region of deviation), the advantage of the 123 superconductor based on A will not be lost and no significant decrease in the temperature at which oxygen is absorbed and in the superconducting transition temperature Tc will occur.

Furthermore, up to about half the number of Ba atoms can be replaced with Sr without causing a significant change in the superconducting characteristics or in the film surface condition

That is, when the 123 superconductor constituted mainly from A element, Ba (a part of which may be replaced with Sr), Cu and oxygen is made to include B element in a particular proportion as a constituent, such an advantage of the 123 superconductor film based on A that all the required oxygen is absorbed so as to achieve good superconducting characteristics without annealing in an oxygen atmosphere at a low temperature is not lost while the advantage of the 123 superconductor based on B, that is, the tolerable margin of the composition, is provided at the same time.

Through a number of experiments, it has been confirmed that the composition of a 123 superconductor film that has a smooth surface and consists of pure c-axis orientation film and is capable of achieving zero electric resistance at a temperature above the temperature of liquid nitrogen is represented by chemical formula AₓB_{(3-x-y)}C_{y}Cu_{z}O_{7-d} (where x ≦ 0.99, y ≦ 1.99, 2.60 ≦ (x + y) ≦ 2.98, 2.70 ≦ z ≦ 3.30 and (7-d) is a value that satisfies the requirement of valence), when one or more elements selected from the group of Gd, Dy, Ho, Er, Tm, Yb, Lu and Y is represented by A, one or more elements selected from the group of La, Nd, Sm and Eu is represented by B and Ba₁₋ₛSrₛ (where 0 ≦ s ≦ 0.50) is represented by C, and that it becomes difficult to reliably manufacture the 123 superconductor film that has smooth surface and shows good superconductivity (particularly high superconducting transition temperature Tc) when the composition of the film deviates from this range.

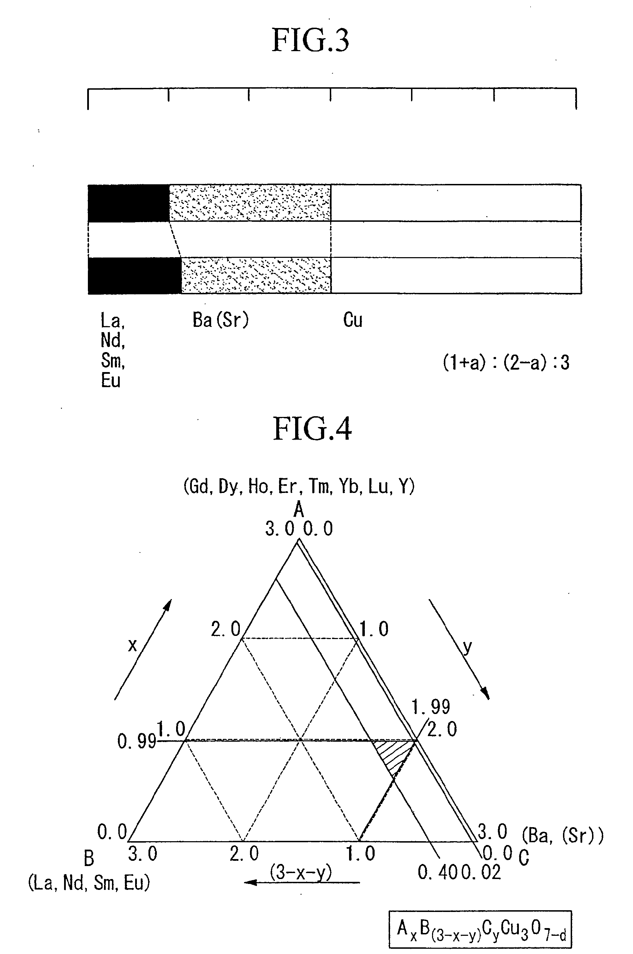

Fig. 4 shows the contents of A, B and C, wherein a hatched region represents the range of compositions of the high temperature superconductor film according to the present invention.

The 123 superconductor film of composition in this region that allows it to reliably achieve the characteristics of a high temperature superconductor film with high superconducting transition temperature Tc is very useful in manufacturing superconductor electronic devices or superconducting wires.

Additionally, it is known that Ca, besides the B element, can also substitute at the atomic sites of A and Ba of the 123 superconductor.

However, since Ca causes a large decrease in Tc compared to B element for a given amount of substitution, substitution with only a very small amount of Ca is allowed in order to maintain a high level of Tc. Furthermore, the permissible amount of substitution is not sufficient to provide the margin of composition that is effective to maintain surface smoothness of the film. As a result, favorable effect similar to that of element B cannot be expected from Ca.

Manufacture of the 123 superconductor according to the present invention is preferably carried out by forming a film of 123 superconductor composition on a substrate by means of a physical film forming process such as sputtering or laser deposition using a target having a composition represented by chemical formula AₓB_{(3-x-y)}C_{y}Cu_{z}O_{7-d} (where x ≦ 0.99, y ≦ 1.99, 2.60 ≦ (x + y) ≦ 2.98, 2.70 ≦ z ≦ 3.30 and (7-d) is a value that satisfies the requirement of valence), and then cooling the film that has been formed in an atmosphere that includes oxygen.

Surface smoothness of the 123 superconductor film can be evaluated by observing the number of precipitations, bumps and dents on the film surface with a microscope.

By correlating the measurements of superconductor characteristics (superconducting transition temperature Tc) of the 123 superconductor film obtained in experiments with the number of precipitations, bumps and dents having sizes that could not be contained within an area of 1 µm square that are observed in an area of 30 µm square on the surface of the superconductor film as observed under an optical microscope at a magnification of 1000 times, it was found that good superconducting characteristics (superconducting transition temperature Tc) can be ensured when the number of precipitations, bumps and dents in the superconductor film is 10 or less. It was also found that the superconductor characteristics of the 123 superconductor film can be improved further when the number of precipitations, bumps and dents having sizes that could not be contained within an area of 1 µm square in the unit area is 5 or less.

While the number of precipitations, bumps and dents having sizes that could not be contained within an area of 1 µm square in the unit area of the 123 superconductor film surface can be controlled by means of the composition of the target material used in forming the film, other film forming conditions such as substrate temperature also have influence, and the effects of these factors should be examined before forming the film.

The present invention will now be described in detail by way of examples.

### EXAMPLES

### [Example 1]

In this example, an attempt was made to manufacture a thin superconductor film by a high frequency sputtering process.

With the application to high reliability electronic device taken into consideration, off-axis sputtering operation was performed in order to form a thin superconductor film having as smooth a surface as possible.

### (Reference Test)

First, an experiment was conducted to manufacture a thin film of ordinary composition YBa₂Cu₃O_{7-d} (where (7-d) has the meaning described previously: the same applies hereinafter), as a reference.

The thin film was formed by using a sintered material YBa₂Cu₃O_{7-d} of stoichiometrical composition as the target on a substrate of La_{0.3}Sr_{1.7}AlTaO₆ (LSAT) (100).

Since the target was put in use, the experiment of forming the film was repeated two or three times every day until the preferable film forming conditions were determined, which took about two weeks.

The procedure and conditions of forming the film thus were determined to be as follows.
1) Pressure in a chamber is maintained at 120 mTorr by controlling the discharge rate while supplying Ar and oxygen gases at flow rates of 9 ml/min. and 1 cc/min., respectively.
2) Plasma is ignited with high frequency output of 50 W, and the target surface is stabilized in equilibrium through pre-sputtering by maintaining the discharge for about one hour.
3) Film forming operation is started by opening a shutter installed in front of the substrate that is heated to 740°C. The substrate is located 30 mm vertically away from a point that is 40 mm away from the target surface.
4) After three hours of deposition, the heater is turned off and oxygen is introduced to a pressure of 300 Torr so as to quench the film.
The thin film formed in the above process showed a thickness of 180 nm and a very smooth surface without foreign matter on the surface when observed with an optical microscope with at a magnification of 1000 times, as shown in Fig. 5A.

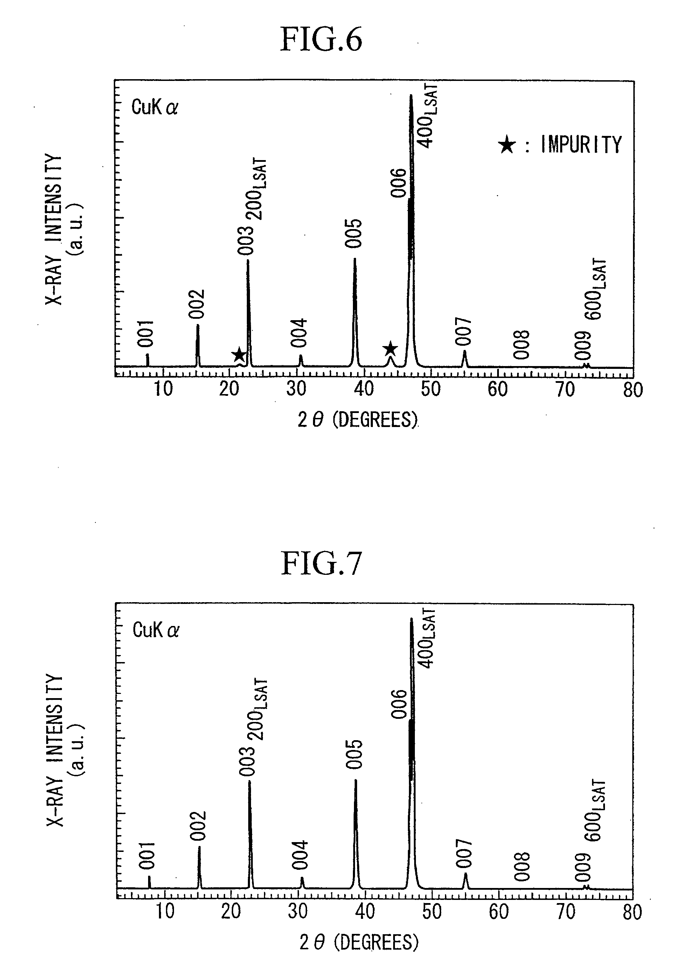

X-ray diffraction (XRD) pattern of this thin film is shown in Fig. 6. The XRD pattern was obtained by scanning over a range 2θ*-θ* with the CuKα line. The XRD pattern shows that this thin film is a 123 superconductor having c-axis orientation. However, some impurity peaks were found at 2θ = 21.5 and 43.9°. These impurity peaks are probably caused by deviation of the composition. Letters "a.u." along the abscissa in Fig. 6 stands for arbitrary unit.

The thin film described above showed zero resistance at 85K in resistivity measurement by direct current 4-terminal method.

Similar experiments of film formation were carried out while changing the substrate temperature, of which results are summarized in Table 1.

**Table 1**

| Substrate temperature | OM | Result of X-ray diffraction | Tc (zero) | Composition of film (Proportion of atoms) | | |
|---|---|---|---|---|---|---|
| (°C) | (pieces) | (crystal orientation axis) | (K) | x | y | z |
| 780 | 11 | c (+ impurity) | 76 | 0.94 | 2.04 | 2.43 |
| 710 | 4 | c (+ impurity) | 86 | 0.94 | 2.06 | 2.54 |
| 760 | 2 | c (+ impurity) | 86 | 0.97 | 2.03 | 2.66 |
| 750 | 0 | c (+ impurity) | 84 | 1.01 | 1.99 | 2.82 |
| 740 | 0 | c (+ impurity) | 85 | 0.94 | 2.06 | 2.91 |
| 730 | 1 | c (+ impurity) | 85 | 0.98 | 2.02 | 2.90 |
| 720 | 6 | c (+ impurity) | 84 | 1.03 | 1.97 | 2.94 |
| 710 | 8 | a+c (+ impurity) | 82 | 0.97 | 2.03 | 3.00 |
| 700 | 10 | a+c (+ impurity) | 81 | 1.01 | 1.99 | 2.98 |
| 690 | 10 | a+c (+ impurity) | 80 | 1.02 | 1.98 | 2.96 |
| Note 1: "OM" means the number of precipitations, bumps and dents having sizes that could not be contained within an area of 1 µm square that are observed in an area of 30 µm square on the surface of the thin film when observed under an optical microscope at a magnification of 1000 times. | | | | | | |
| 2: "Composition of film" means the proportion of cations Y: Ba: Cu = x:y:z of the film determined by ICP emission spectrochemical analysis. | | | | | | |

The X-ray diffraction (XRD) analysis shown in Table 1 shows that grains oriented in a axis become mixed when the substrate temperature becomes lower.

Examination of the composition (cation atom ratio) of the thin film determined by the ICP emission spectrochemical analysis showed a tendency of Cu content to decrease as the substrate temperature increased.

Proportions of Y: Ba: Cu of integral numbers 1.00:2.00:3.00 were not obtained under such conditions that allowed the formation of a c-axis orientation film.

Although the thin superconductor films manufactured in the experiments described above showed impurity in X-ray diffraction (XRD) analysis as shown in Table 1, the surface was smooth and the superconducting transition temperature Tc (zero) was higher than the nitrogen liquid temperature (77K). Therefore, film forming experiments were continued under the same conditions using the same equipment and target.

However, surface smoothness and superconducting transition temperature Tc (zero) of the film being formed gradually became unsatisfactory.

This is believed to be because since the surface conditions of the inner wall of the film forming chamber changed as the film forming operation was repeated, and change in the shape of target surface was also observed due to wear of the target being impinged, these and other factors caused the deviation from the preferable film forming conditions that were determined at the start.

Results of the film forming operations repeated at substrate temperatures from 720 to 770°C with the equipment, target and film forming conditions for three months are shown in Table 2.

**Table 2**

| Substrate temperature | Results obtained after 3 months of film forming operations | | | | | |
|---|---|---|---|---|---|---|
| (°C) | OM | Result of X-ray diffraction | Tc (zero) | Composition of film (Proportion of atoms) | | |
| | (pieces) | (crystal orientation axis) | (K) | x | y | z |
| 770 | 12 | c (+ Impurity) | 74 | 0.87 | 2.13 | 2.34 |
| 760 | 11 | c (+ Impurity) | 74 | 0.88 | 2.12 | 2.50 |
| 750 | 10 | c (+ Impurity) | 78 | 0.89 | 2.11 | 2.75 |
| 740 | 5 | c (+ Impurity) | 79 | 0.91 | 2.09 | 2.79 |
| 730 | 11 | c (+ Impurity) | 76 | 0.91 | 2.09 | 2.81 |
| 720 | 13 | c (+ Impurity) | 72 | 0.92 | 2.08 | 2.81 |
| Note 1: "OM" means the number of precipitations, bumps and dents having sizes that could not be contained within an area of 1 µm square that are observed in an area of 30 µm square on the surface of the thin film when observed under an optical microscope at a magnification of 1000 times. | | | | | | |
| 2: "Composition of film" means the proportion of cations Y: Ba: Cu = x:y:z of the film determined by the ICP emission spectrochemical analysis. | | | | | | |

As will be clear from the results shown in Table 2, the composition deviates from the desired one, the number of precipitations, bumps and dents increases and smoothness of the film surface deteriorates as the experiment of forming the film was continued for three months. In a film having 11 or more precipitations, bumps and dents, the superconducting transition temperature Tc (zero) is lower than the liquid nitrogen temperature of 77K.

### (Example Test 1)

Then an experiment for manufacturing a thin film of Y_{0.9}La_{0.2}Ba_{1.9}Cu₃O_{7-d} was conducted.

In this experiment, sintered material Y_{0.9}La_{0.2}Ba_{1.9}Cu₃O_{7-d} of stoichiometrical composition was used as the target, and the film was formed under the same conditions as those of the Reference Test (experiment of forming YBa₂Cu₃O_{7-d} film) except for placing the substrate 30 mm vertically away from a point that was 45 mm away from the target surface.

In this experiment, it took about three days after the start of using the target to find out the preferable conditions of forming films.

In experiments of forming Y_{0.9}La_{0.2}Ba_{1.9}Cu₃O_{7-d} films while changing the substrate temperature under the conditions described above, satisfactory films were obtained in a wide temperature range around 740°C (substrate temperature).

Data measured when forming the thin film (180 nm thick) are summarized in Table 3.

**Table 3**

| Substrate temperature | OM | Result of X-ray diffraction | Tc (zero) | Composition of film (Proportion of atoms) | | |
|---|---|---|---|---|---|---|
| (°C) | (pieces) | (crystal orientation axis) | (K) | x | y | z |
| 780 | 4 | c (+ Impurity) | 85 | 0.92 | 1.88 | 2.81 |
| 770 | 0 | c | 84 | 0.93 | 1.90 | 2.90 |
| 760 | 0 | c | 84 | 0.92 | 1.91 | 2.92 |
| 750 | 0 | c | 84 | 0.91 | 1.90 | 3.01 |
| 740 | 0 | c | 84 | 0.90 | 1.89 | 3.01 |
| 730 | 0 | c | 84 | 0.90 | 1.90 | 3.02 |
| 720 | 0 | c | 84 | 0.89 | 1.90 | 2.99 |
| 710 | 0 | a+c | 84 | 0.89 | 1.90 | 3.00 |
| 700 | 3 | a+c | 81 | 0.90 | 1.90 | 2.98 |
| 690 | 3 | a+c | 81 | 0.90 | 1.91 | 2.96 |
| Note 1: "OM" means the number of precipitations, bumps and dents having sizes that could not be contained within an area of 1 µm square that are observed in an area of 30 µm square on the surface of the thin film when observed under an optical microscope at a magnification of 1000 times. | | | | | | |
| 2: "Composition of film" means the values of x, y and z that represents the proportion of cations Y: La: Ba: Cu = x:(3-x-y):y:z of the film determined by ICP emission spectrochemical analysis. | | | | | | |

The X-ray diffraction (XRD) pattern obtained by scanning over a range from 2θ to θ with Cu-Kα line on the thin film thus formed showed no impurity peak of 2θ = 42 to 45° that were observed in the case of YBa₂Cu₃O_{7-d}.

The results shown in Table 3 indicate that the region where the number of precipitations, bumps and dents is zero is extended compared to the case of YBa₂Cu₃O_{7-d}.

This is considered to be the effect of the tolerable margin brought about for the deviation of composition by the partial substitution with La.

Fig. 7 shows the X-ray diffraction (XRD) pattern of the thin film formed at a substrate temperature of 740°C.

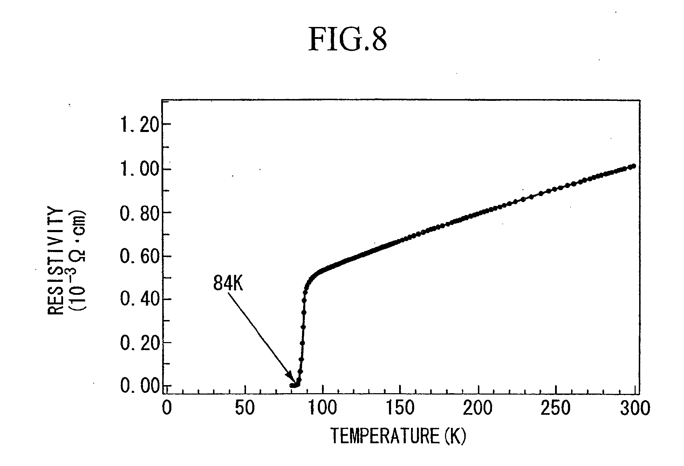

Pure c-axis orientation film obtained in this experiment showed zero resistance at 84K as will be seen from Fig. 8 which shows the result of resistivity measurement by direct current 4-terminal method.

Results of film forming operations repeated at substrate temperatures from 710 to 770°C with the equipment, target and film forming conditions for three months are shown in Table 4.

**Table 4**

| Substrate temperature | Results obtained after 3 months of film forming operations | | | | | |
|---|---|---|---|---|---|---|
| (°C) | OM | Result of X-ray diffraction | Tc (zero) | Composition of film (Proportion of atoms) | | |
| | (pieces) | (crystal orientation axis) | (K) | x | y | z |
| 770 | 0 | c | 85 | 0.92 | 1.89 | 2.91 |
| 760 | 0 | c | 85 | 0.92 | 1.91 | 2.95 |
| 750 | 0 | c | 83 | 0.91 | 1.89 | 3.00 |
| 740 | 0 | c | 84 | 0.91 | 1.88 | 3.00 |
| 730 | 0 | c | 84 | 0.90 | 1.91 | 2.99 |
| 720 | 0 | c | 84 | 0.88 | 1.91 | 2.99 |
| 710 | 0 | c | 83 | 0.89 | 1.91 | 3.02 |
| Note 1: "OM" means the number of precipitations, bumps and dents having sizes that could not be contained within an area of 1 µm square that are observed in an area of 30 µm square on the surface of the thin film when observed under an optical microscope at a magnification of 1000 times. | | | | | | |
| 2: "Composition of film" means the values of x, y and z that represent the proportion of cations Y: La: Ba: Cu = x:(3-x-y):y:z of the film determined by ICP emission spectrochemical analysis. | | | | | | |

From the results shown in Table 4, it can also be confirmed that significant deterioration in the smoothness of the film surface and in superconducting transition temperature Tc (zero) as encountered in the case of YBa₂Cu₃O_{7-d} was not observed when forming the Y_{0.9}La_{0.2}Ba_{1.9}Cu₃O_{7-d} films even after repeating the operations for three months.

### (Example Test 2)

In this experiment, thin YₓLa_{(3-x-y)}Ba_{y}Cu_{z}O_{7-d} film was formed by changing the composition of the target so as to change the proportions of Y, La, Ba and Cu atoms.

The film was formed under the same conditions as the optimum conditions for Y_{0.9}La_{0.2}Ba_{1.9}Cu₃O_{7-d} (substrate temperature 740°C).

The results of this film forming experiment are summarized in Table 5.

**Table 5**

| Target composition | | | OM | Result of X-ray diffraction | Tc (zero) | Composition of film | | |
|---|---|---|---|---|---|---|---|---|
| X | Y | Z | (pieces) | (crystal orientation axis) | (K) | x | y | z |
| 1.00 | 2.00 | 3.00 | 0 | c (+ Impurity) | 85 | 0.94 | 2.06 | 2.91 |
| 0.99 | 1.99 | 3.00 | 0 | c | 85 | 0.99 | 1.99 | 2.97 |
| 0.98 | 1.98 | 3.00 | 0 | c | 85 | 0.97 | 1.98 | 2.99 |
| 0.90 | 1.90 | 3.00 | 0 | c | 84 | 0.90 | 1.89 | 3.01 |
| 0.85 | 1.85 | 3.00 | 0 | c | 84 | 0.83 | 1.87 | 2.99 |
| 0.80 | 1.80 | 3.00 | 0 | c | 79 | 0.80 | 1.80 | 3.03 |
| 0.75 | 1.75 | 3.00 | 0 | c | 73 | 0.74 | 1.77 | 3.04 |
| 0.70 | 1.70 | 3.00 | 0 | c | 69 | 0.71 | 1.72 | 3.01 |
| 0.99 | 1.66 | 3.00 | 0 | c | 84 | 0.99 | 1.64 | 3.02 |
| 0.99 | 1.61 | 3.00 | 0 | c | 81 | 0.99 | 1.61 | 3.02 |
| 0.99 | 1.56 | 3.00 | 0 | c | 75 | 0.99 | 1.54 | 3.07 |
| 0.66 | 1.99 | 3.00 | 0 | c | 82 | 0.64 | 1.98 | 3.00 |
| 0.61 | 1.99 | 3.00 | 0 | c | 79 | 0.61 | 1.99 | 3.00 |
| 0.56 | 1.99 | 3.00 | 0 | c | 72 | 0.55 | 1.98 | 3.03 |
| 0.99 | 1.99 | 3.10 | 0 | c | 86 | 0.99 | 1.99 | 3.09 |
| 0.99 | 1.99 | 3.20 | 0 | c | 84 | 0.99 | 1.98 | 3.18 |
| 0.99 | 1.99 | 3.30 | 0 | c | 81 | 0.99 | 1.99 | 3.30 |
| 0.99 | 1.99 | 3.40 | 6 | c (+ Impurity) | 76 | 0.99 | 1.98 | 3.38 |
| 0.99 | 1.99 | 3.50 | 9 | c (+ Impurity) | 75 | 1.00 | 1.99 | 3.49 |
| 0.99 | 1.99 | 2.90 | 0 | c | 85 | 0.99 | 1.99 | 2.91 |
| 0.99 | 1.99 | 2.80 | 0 | c | 83 | 0.99 | 1.98 | 2.79 |
| 0.99 | 1.99 | 2.70 | 0 | c | 82 | 0.99 | 1.99 | 2.70 |
| 0.99 | 1.99 | 2.60 | 7 | c (+ Impurity) | 74 | 0.99 | 1.98 | 2.63 |
| 0.99 | 1.99 | 2.50 | 9 | c (+ Impurity) | 71 | 1.00 | 1.99 | 2.54 |
| 0.80 | 1.80 | 3.10 | 0 | c | 86 | 0.80 | 1.80 | 3.09 |
| 0.80 | 1.80 | 3.20 | 0 | c | 85 | 0.78 | 1.81 | 3.12 |
| 0.80 | 1.80 | 3.30 | 0 | c | 81 | 0.80 | 1.80 | 3.30 |
| 0.80 | 1.80 | 3.40 | 7 | c (+ Impurity) | 74 | 0.79 | 1.78 | 3.39 |
| 0.80 | 1.80 | 3.50 | 9 | c (+ Impurity) | 70 | 0.79 | 1.80 | 3.50 |
| 0.80 | 1.80 | 2.90 | 0 | c | 87 | 0.80 | 1.80 | 2.92 |
| 0.80 | 1.80 | 2.80 | 0 | c | 84 | 0.78 | 1.81 | 2.79 |
| 0.80 | 1.80 | 2.70 | 0 | c | 82 | 0.80 | 1.80 | 2.70 |
| 0.80 | 1.80 | 2.60 | 8 | c (+ Impurity) | 76 | 0.79 | 1.79 | 2.59 |
| 0.80 | 1.80 | 2.50 | 9 | c (+ Impurity) | 73 | 0.79 | 1.80 | 2.50 |
| Note 1: "OM" means the number of precipitations, bumps and dents having sizes that could not be contained within an area of 1 µm square that are observed in an area of 30 µm square on the surface of the thin film when observed under an optical microscope at a magnification of 1000 times. | | | | | | | | |
| 2: "Composition of film" means the values of x, y and z that represent the proportion of cation Y:Ba:Cu = x:(3-x-y):y:z of the film determined by the ICP emission spectrochemical analysis. | | | | | | | | |

In Table 5, compositions of the target and the film formed thereby are represented by the values of x, y and z in the chemical formula YₓLa_{(3-x-y)}Ba_{y}Cu_{z}O_{7-d}.

From the results shown in Table 5, it can be seen that a pure c-axis orientation film that has a smooth surface and shows superconducting transition temperature Tc (zero) higher than 77K can be obtained in a range of composition x ≦ 0.99, y ≦ 1.99, 2.60 ≦ (x + y) ≦ 2.98 and 2.70 ≦ z ≦ 3.30.

Similarly good results were obtained in the case in which Nd, Sm or Eu was used instead of La, and Gd, Dy, Ho, Er, Tm, Yb or Lu was used instead of Y as a component of the thin film.

In the case in which up to half of the Ba atoms of the thin film component were replaced with Sr, too, similarly good results were obtained.

### [Example 2]

In this example, an attempt was made to manufacture thin superconductor films by a laser deposition process.

In this case, too, with the application to high reliability electronic device taken into consideration, utmost care was exercised in order to form a high temperature superconductor thin film having as smooth a surface as possible.

### (Reference Test)

First, an experiment was conducted to manufacture a thin film of ordinary composition YBa₂Cu₃O_{7-d}.

The thin film was formed by using a sintered material YBa₂Cu₃O_{7-d} of stoichiometrical composition as the target on a substrate of La_{0.3}Sr_{1.7}AlTaO₆ (LSAT) (100).

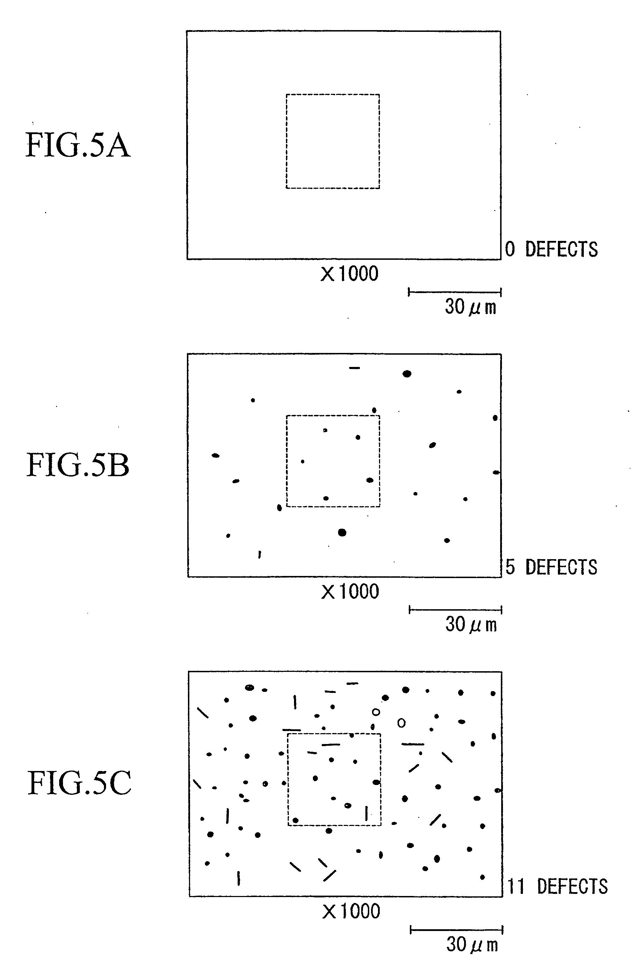

The procedure and conditions of forming the film were as follows.
1) Pressure in a chamber is maintained at 200 mTorr by controlling the discharge rate while supplying oxygen gas at a flow rate of 20 ml/min.
2) The target surface is irradiated with KrF laser beam having output power of 400 mJ at a frequency of 5 Hz, so as to instantaneously vaporize the target material and cause the vapor to deposit on the substrate located at a distance of 60 mm. Energy density of laser applied to the target surface was set to 1.5 J/cm². The target is rotated so that any point of the surface would not be irradiated for a longer time than the other.
3) After irradiating with the laser beam for 10 minutes so as to stabilize the target surface, film forming operation is started by opening a shutter installed in front of the substrate that is heated to 740°C.
4) After 30 minutes of deposition, the heater is turned off and oxygen is introduced to a pressure of 300 Torr so as to quench the film.
The thin film formed in the above process showed a thickness of 200 nm. About 11 pieces of precipitate having the shape of round particles or needles and sizes that could not be contained within an area of 1 µm square were recognized in an area of 30 µm square on the surface as shown in Fig. 5C, when observed with an optical microscope at a magnification of 1000 times. Such a precipitation is commonly encountered in the case of thin films formed by laser deposition, and it is said that grains are usually formed in a concentration from 10⁶ to 10⁸/ cm² (from about 10 to 1000 in an area of 30 µm square) in the case of YBa₂Cu₃O_{7-d}. Therefore, the film obtained in this experiment may be regarded as having very good quality.

X-ray diffraction (XRD) pattern of this thin film obtained by scanning over a range from 2θ to θ with CuKα line shows that this thin film is a 123 superconductor having c-axis orientation. No impurity peaks were observed in this thin film.

The thin film described above showed zero resistance at 87K in resistivity measurement by direct current 4-terminal method.

ICP emission spectrochemical analysis showed that this thin film was a YBa₂Cu₃O_{7-d} film having substantially stoichiometrical composition of Y: Ba: Cu ratio 0.98: 2.02: 3.05.

Similar experiments of film formation were carried out while changing the substrate temperature, of which results are summarized in Table 6.

**Table 6**

| Substrate temperature | OM | Result of X-ray diffraction | Tc (zero) | Jc (at 77K) | Composition of film (Atom ratio) | | |
|---|---|---|---|---|---|---|---|
| (°C) | (pieces) | (crystal orientation axis) | (K) | (MA/cm²) | x | y | z |
| 780 | 28 | c (+ Impurity) | 86 | -- | -- | -- | -- |
| 770 | 15 | c | 88 | 0.23 | 1.01 | 1.99 | 2.89 |
| 760 | 12 | c | 87 | 0.80 | 1.02 | 1.98 | 3.00 |
| 750 | 12 | c | 82 | 0.21 | 1.00 | 2.00 | 3.04 |
| 740 | 11 | c | 83 | 0.33 | 0.98 | 2.02 | 3.05 |
| 730 | 12 | c | 81 | 0.18 | 0.97 | 2.03 | 3.02 |
| 720 | 19 | c | 83 | 0.16 | 1.01 | 1.99 | 3.06 |
| 710 | 36 | c | 80 | 0.08 | 1.00 | 2.00 | 3.06 |
| 700 | 39 | c | 79 | 0.06 | 1.00 | 2.00 | 3.05 |
| 690 | 40 | a+c | 78 | -- | -- | -- | -- |
| 680 | 46 | a+c (+ Impurity) | 77 | -- | -- | -- | -- |
| 670 | 39 | a+c (+ Impurity) | 76 | -- | -- | -- | -- |
| Note 1: "OM" means the number of precipitations, bumps and dents having sizes that could not be contained within an area of 1 µm square that are observed in an area of 30 µm square on the surface of the thin film when observed under an optical microscope at a magnification of 1000 times. | | | | | | | |
| 2: "Composition of film" means the proportion of cations Y:Ba:Cu = x:y:z of the film determined by the ICP emission spectrochemical analysis. | | | | | | | |

Table 6 also shows the results of measuring the critical current density at 77K, that is an important characteristic of thin superconductor film.

From Table 6, it can be seen that 11 or more precipitations, bumps and dents were observed in any of the films that were formed.

It can also be confirmed that c-axis orientation film that shows superconducting transition temperature Tc (zero) not lower than the temperature of liquid nitrogen and does not include impurity could be obtained in a temperature range from 700 to 770°C.

Critical current density Jc at 77K was 0.80 MA/ cm² at the maximum.

### (Example Test 1)

An experiment of manufacturing Y_{0.9}La_{0.2}Ba_{1.9}Cu₃O_{7-d} film was conducted.

This experiment was conducted under the same conditions as those of Reference Test (experiment of forming YBa₂Cu₃O_{7-d} film) except for using a sintered material Y_{0.9}La_{0.2}Ba_{1.9}Cu₃O_{7-d} of stoichiometrical composition as the target.

Experiments of forming the thin Y_{0.9}La_{0.2}Ba_{1.9}Cu₃O_{7-d} film was conducted while changing the substrate temperature under the conditions described above, with the results of measuring the thin film thus obtained (200 nm thick) are summarized in Table 7.

**Table 7**

| Substrate temperature | OM | Result of X-ray diffraction | Tc (zero) | Jc (at 77K) | Composition of film (Proportion of atoms) | | |
|---|---|---|---|---|---|---|---|
| (°C) | (pieces) | (crystal orientation axis) | (K) | (MA/cm²) | x | y | z |
| 780 | 15 | c (+ Impurity) | 89 | - | -- | -- | -- |
| 770 | 11 | c | 88 | 0.90 | 0.88 | 1.89 | 2.95 |
| 760 | 10 | c | 88 | 1.8 | 0.89 | 1.91 | 2.96 |
| 750 | 7 | c | 88 | 2.9 | 0.89 | 1.89 | 2.99 |
| 740 | 5 | c | 87 | 3.3 | 0.90 | 1.89 | 3.01 |
| 730 | 8 | c | 87 | 1.8 | 0.91 | 1.90 | 3.02 |
| 720 | 10 | c | 87 | 1.1 | 0.92 | 1.90 | 3.01 |
| 710 | 17 | c | 83 | 0.57 | 0.89 | 1.89 | 3.03 |
| 700 | 18 | c | 80 | 0.09 | 0.90 | 1.90 | 3.02 |
| 690 | 21 | a+c | 79 | - | -- | -- | -- |
| 680 | 20 | a + c (+ impurity) | 77 | - | -- | -- | -- |
| 670 | 19 | a + c (+ impurity) | 77 | - | -- | -- | -- |
| Note 1: "OM" means the number of precipitations, bumps and dents having sizes that could not be contained within an area of 1 µm square that were observed in an area of 30 µm square on the surface of the thin film when observed under an optical microscope at a magnification of 1000 times. | | | | | | | |
| 2: "Composition of film" means the proportion of cations Y:Ba:Cu = x:y:z of the film determined by ICP emission spectrochemical analysis. | | | | | | | |

From the results shown in Table 7, it can be seen that, when observed under an optical microscope at a magnification of 1000 times, the thin films obtained in this experiment has better surface smoothness than the YBa₂Cu₃O_{7-d} film. This is supposedly because partial substitution of La decreased the number of precipitations, bumps and dents that originated from the deviation of composition. Specifically, the number of precipitations, bumps and dents (OM) on the film surface is significantly decreased simply by replacing Y and Ba partially with a small amount of La in the thin film constituted mainly from YBa₂Cu₃O_{7-d}. It can also be seen that, when the number of precipitations, bumps and dents on the film surface becomes ten or less, critical current density Jc at 77K shows a value not lower than 1.00 MA/cm².

Fig. 5B shows the surface of the thin film formed when the substrate temperature was set to 740°C as shown in Table 7, observed with an optical microscope. It is quite remarkable that, as indicated by this result, the number of precipitations, bumps and dents of sizes that could not be contained within an area of 1 µm square recognized in an area of 30 µm square of the thin film formed by laser deposition decreased to 5.

It has been known from past research that a thin film of smoother surface can be made from NdBa₂Cu₃O_{7-d} than from YBa₂Cu₃O_{7-d}, when laser deposition process is employed. With regard to film forming process using a sintered target, however, the only data published so far is the defect density of 6 × 10⁵/cm² (count of 5.4 in an area of 30 µm square) that was achieved with NdBa₂Cu₃O_{7-d} upon tedious examination of the film forming conditions (H. Zama et al., Jpn. J. Appl. Phys., 38 (1999), pp923).

### (Example Test 2)

In this experiment, thin films of YₓLa_{(3-x-y)}Ba_{y}Cu_{z}O_{7-d} were formed by changing the composition of the target so as to change the proportions of Y, La, Ba and Cu atoms.

The film was formed under the same conditions as the optimum conditions for Y_{0.9}La_{0.2}Ba_{1.9}Cu₃O_{7-d} (substrate temperature 740°C).

The results of this film forming experiment are summarized in Table 8.

**Table 8**

| Target composition | | | OM | Result of X-ray diffraction | Tc (zero) | Jc (at 77K) | Composition of film | | |
|---|---|---|---|---|---|---|---|---|---|
| X | Y | Z | (pieces) | (crystal orientation axis) | (K) | (Ma/cm⁷) | x | y | z |
| 1.00 | 2.00 | 3.00 | 11 | c | 83 | 0.33 | 0.98 | 2.02 | 3.05 |
| 0.99 | 1.99 | 3.00 | 5 | c | 86 | 2.0 | 0.99 | 1.99 | 2.99 |
| 0.98 | 1.98 | 3.00 | 4 | c | 88 | 1.9 | 0.97 | 1.98 | 2.99 |
| 0.90 | 1.90 | 3.00 | 5 | c | 87 | 3.3 | 0.90 | 1.89 | 3.01 |
| 0.85 | 1.85 | 3.00 | 7 | c | 86 | 2.2 | 0.84 | 1.86 | 2.99 |
| 0.80 | 1.80 | 3.00 | 6 | c | 84 | 1.0 | 0.80 | 1.80 | 2.99 |
| 0.75 | 1.75 | 3.00 | 7 | c | 76 | - | 0.75 | 1.79 | 3.00 |
| 0.70 | 1.70 | 3.00 | 6 | c | 71 | - | 0.70 | 1.72 | 3.04 |
| 0.99 | 1.66 | 3.00 | 8 | c | 83 | 1.1 | 0.99 | 1.66 | 3.00 |
| 0.99 | 1.61 | 3.00 | 7 | c | 82 | 1.2 | 0.99 | 1.61 | 3.03 |
| 0.99 | 1.56 | 3.00 | 7 | c | 76 | - | 0.98 | 1.55 | 2.99 |
| 0.66 | 1.99 | 3.00 | 9 | c | 84 | 1.2 | 0.66 | 1.99 | 3.02 |
| 0.61 | 1.99 | 3.00 | 8 | c | 85 | 1.1 | 0.61 | 1.99 | 3.01 |
| 0.56 | 1.99 | 3.00 | 11 | c | 80 | 0.51 | 0.55 | 1.98 | 3.02 |
| 0.99 | 1.99 | 3.05 | 5 | c | 86 | 1.5 | 0.99 | 1.99 | 3.06 |
| 0.99 | 1.99 | 3.10 | 8 | c | 85 | 1.6 | 0.99 | 1.98 | 3.10 |
| 0.99 | 1.99 | 3.15 | 9 | c | 84 | 1.7 | 0.98 | 1.99 | 3.14 |
| 0.99 | 1.99 | 3.20 | 8 | c | 85 | 1.3 | 0.99 | 1.98 | 3.18 |
| 0.99 | 1.99 | 3.25 | 8 | c | 84 | 1.1 | 0.99 | 1.99 | 3.23 |
| 0.99 | 1.99 | 3.30 | 9 | c | 81 | 1.0 | 0.99 | 1.99 | 3.30 |
| 0.99 | 1.99 | 3.35 | 11 | c (+ Impurity) | 76 | - | 0.99 | 1.99 | 3.35 |
| 0.99 | 1.99 | 3.40 | 11 | c (+ Impurity) | 76 | - | 0.98 | 1.98 | 3.38 |
| 0.99 | 1.99 | 3.50 | 12 | c (+ Impurity) | 75 | - | 0.97 | 1.98 | 3.49 |
| 0.99 | 1.99 | 2.95 | 5 | c | 86 | 1.9 | 0.99 | 1.99 | 2.96 |
| 0.99 | 1.99 | 2.90 | 5 | c | 84 | 1.8 | 0.99 | 1.98 | 2.89 |
| 0.99 | 1.99 | 2.85 | 4 | c | 81 | 1.7 | 0.98 | 1.99 | 2.84 |
| 0.99 | 1.99 | 2.80 | 7 | c | 81 | 1.2 | 0.99 | 1.97 | 2.79 |
| 0.99 | 1.99 | 2.75 | 10 | c | 82 | 1.1 | 0.98 | 1.98 | 2.74 |
| 0.99 | 1.99 | 2.70 | 10 | c | 81 | 1.0 | 0.99 | 1.99 | 2.70 |
| 0.99 | 1.99 | 2.65 | 12 | c (+ Impurity) | 76 | - | 0.99 | 1.98 | 2.49 |
| 0.99 | 1.99 | 2.60 | 14 | c (+ Impurity) | 75 | - | 0.97 | 1.98 | 2.59 |
| 0.99 | 1.99 | 2.50 | 20 | c (+ Impurity) | 75 | - | 0.97 | 1.99 | 2.51 |
| 0.80 | 1.80 | 3.05 | 5 | c | 83 | 1.4 | 0.80 | 1.80 | 3.04 |
| 0.80 | 1.80 | 3.01 | 6 | c | 82 | 1.1 | 0.79 | 1.80 | 3.10 |
| 0.80 | 1.80 | 3.15 | 7 | c | 82 | 1.1 | 0.79 | 1.80 | 3.14 |
| 0.80 | 1.80 | 3.20 | 7 | c | 81 | 1.0 | 0.79 | 1.79 | 3.18 |
| 0.80 | 1.80 | 3.25 | 6 | c | 81 | 1.0 | 0.80 | 1.81 | 3.23 |
| 0.80 | 1.80 | 3.30 | 9 | c | 80 | 1.0 | 0.80 | 1.80 | 3.30 |
| 0.80 | 1.80 | 3.35 | 12 | c (+ Impurity) | 76 | - | 0.79 | 1.99 | 3.35 |
| 0.80 | 1.80 | 3.40 | 13 | c (+ Impurity) | 75 | - | 0.78 | 1.98 | 3.38 |
| 0.80 | 1.80 | 3.50 | 19 | c (+ Impurity) | 73 | - | 0.80 | 1.98 | 3.49 |
| 0.80 | 1.80 | 2.95 | 5 | c | 85 | 1.9 | 0.78 | 1.80 | 2.96 |
| 0.80 | 1.80 | 2.90 | 4 | c | 84 | 1.7 | 0.78 | 1.81 | 2.89 |
| 0.80 | 1.80 | 2.85 | 5 | c | 82 | 1.1 | 0.78 | 1.80 | 2.85 |
| 0.80 | 1.80 | 2.80 | 6 | c | 82 | 1.1 | 0.79 | 1.77 | 2.79 |
| 0.80 | 1.80 | 2.75 | 9 | c | 81 | 1.0 | 0.78 | 1.99 | 2.74 |
| 0.80 | 1.80 | 2.70 | 9 | c | 80 | 1.0 | 0.80 | 1.80 | 2.70 |
| 0.80 | 1.80 | 2.65 | 11 | c (+ Impurity) | 76 | - | 0.79 | 1.78 | 2.49 |
| 0.80 | 1.80 | 2.60 | 18 | c (+ Impurity) | 76 | - | 0.78 | 1.78 | 2.59 |
| 0.80 | 1.80 | 2.50 | 22 | c (+ Impurity) | 71 | - | 0.77 | 1.79 | 2.51 |
| Note 1: "OM" means the number of precipitations, bumps and dents having particular sizes included in unit area. | | | | | | | | | |
| 2: "Target composition" and "Composition of film" mean the values of x, y and z of atom ratio Y:La:Ba:Cu = x:(3-x-y):y:z. | | | | | | | | | |

In Table 8, compositions of the target and the film formed thereby are represented by the values of x, y and z in the formula YₓLa_{(3-x-y)}Ba_{y}Cu_{z}O_{7-d}.

From the results shown in Table 8, it can be seen that a pure c-axis orientation film that has a smooth surface and shows superconducting transition temperature Tc (zero) higher than 77K can be obtained in a range of composition x ≦ 0.99, y ≦ 1.99, 2.60 ≦ (x + y) ≦ 2.98 and 2.70 ≦ z ≦ 3.30.

Similarly good results were obtained in case Nd, Sm or Eu was used instead of La, and Gd, Dy, Ho, Er, Tm, Yb or Lu was used instead of Y as a component of the thin film.

In case up to half of Ba atoms of the thin film component were replaced with Sr, too, similarly good results were obtained.

Table 9 shows the results of measuring AₓB_{(3-x-y)}C_{y}Cu_{z}O_{7-d} films (200 nm in thickness and all films satisfied the condition of x ≦ 0.99, y ≦ 1.99, 2.60 ≦ (x + y) ≦ 2.98 and 2.70 ≦ z ≦ 3.30) that were formed by using a sintered target having composition of A_{0.9}B_{0.2}C_{1.9}Cu₃O_{7-d}.

**Table 9**

| Target constituting atoms | | | OM | Result of X-ray diffraction | Tc (zero) | Jc (at 77K) |
|---|---|---|---|---|---|---|
| A | B | C | (pieces) | (crystal orientation axis) | (K) | (MA/cm²) |
| Gd | La | Ba | 7 | c | 87 | 1.9 |
| Gd | La | Ba | 6 | c | 86 | 1.7 |
| Gd | La | Ba | 7 | c | 86 | 1.5 |
| Gd | La | Ba_{0.5}Sr_{0.5} | 10 | c | 81 | 1.0 |
| Yb | La | Ba | 7 | c | 84 | 1.3 |
| Yb | La | Ba | 7 | c | 83 | 1.4 |
| Yb | La | Ba | 6 | c | 84 | 1.4 |
| Yb | La | Ba_{0.5}Sr_{0.5} | 9 | c | 81 | 1.0 |
| Dy | La | Ba | 8 | c | 81 | 1.8 |
| Ho | La | Ba | 7 | c | 81 | 2.0 |
| Er | La | Ba | 9 | c | 81 | 1.8 |
| Tm | La | Ba | 8 | c | 83 | 1.1 |
| Lm | La | Ba | 10 | c | 80 | 1.0 |
| Note 1: Composition of the target is A_{0.9}B_{0.2}C_{1.9}Cu₃O_{7-d}. | | | | | | |
| 2: OM represents the number of precipitations, bumps and dents located within a unit area. | | | | | | |

### [Example 3]

In this example, an attempt was made to manufacture thick superconductor films by laser deposition process.

In this case, with the application to electric wire of high critical current density taken into consideration, utmost care was exercised in order to form a thick high temperature superconductor film having as smooth a surface as possible.

The thick film was formed by using a Ni tape processed by hot rolling so as to achieve oriented structure of the surface as a substrate, and a sintered material A_{0.9}B_{0.2}C_{1.9}Cu₃O_{7-d} of stoichiometrical composition was used as the target.

The procedure and conditions of forming the film were as follows.
1) Pressure in a chamber is maintained at 200 mTorr by controlling the discharge rate while supplying oxygen gas at a flow rate of 20 ml/min.
2) The target surface is irradiated with KrF laser beam having output power of 600 mJ at a frequency of 20 Hz, so as to instantaneously vaporize the target material and cause the vapor to deposit on the substrate located at a distance of 60 mm. Energy density of the laser on the target surface is set to 1.8 J/cm².
3) Film forming operation is started by opening a shutter installed in front of the substrate that is heated to 710°C.
4) After three hours of deposition, the heater is turned off and oxygen is introduced to a pressure of 300 Torr so as to quench the film.

The thick films formed in the process described above were all 1 µm thick.

Table 10 shows the results of measuring the thick films of AₓB_{(3-x-y)}C_{y}Cu_{z}O_{7-d} (all films satisfied the condition of x ≦ 0.99, y ≦ 1.99, 2.60 ≦ (x + y) ≦ 2.98 and 2.70 ≦ z ≦ 3.30) that were formed by using a target having composition of A_{0.9}B_{0.2}C_{1.9}Cu₃O_{7-d}.

**Table 10**

| Target constituting atoms | | | OM | Result of X-ray diffraction | Tc (zero) | Jc (at 77K) |
|---|---|---|---|---|---|---|
| A | B | C | (pieces) | (crystal orientation axis) | (K) | (MA/cm²) |
| Y | La | Ba | 8 | c | 85 | 1.9 |
| Y | Nd | Ba | 7 | c | 86 | 1.5 |
| Y | Eu | Ba | 6 | c | 86 | 1.6 |
| Y | La | Ba_{0.5}Sr_{0.5} | 10 | c | 83 | 1.0 |
| Gd | La | Ba | 9 | c | 87 | 2.0 |
| Gd | Nd | Ba | 8 | c | 85 | 1.9 |
| Gd | Eu | Ba | 7 | c | 86 | 1.7 |
| Gd | La | Ba_{0.5}Sr_{0.5} | 10 | c | 82 | 1.1 |
| Yb | La | Ba | 8 | c | 85 | 1.5 |
| Yb | Nd | Ba | 8 | c | 85 | 1.4 |
| Yb | Eu | Ba | 6 | c | 87 | 1.7 |
| Yb | La | Ba_{0.5}Sr_{0.5} | 9 | c | 81 | 1.0 |
| Dy | La | Ba | 10 | c | 86 | 1.7 |
| Ho | La | Ba | 8 | c | 85 | 1.9 |
| Er | La | Ba | 9 | c | 86 | 1.8 |
| Tm | La | Ba | 9 | c | 86 | 1.4 |
| Lu | La | Ba | 10 | c | 81 | 1.0 |
| Note 1: Composition of the target is A_{0.9}B_{0.2}C_{1.9}Cu₃O_{7-d}. | | | | | | |
| 2: OM represents the number of precipitations, bumps and dents having particular sizes located within a unit area. | | | | | | |

From the results shown in Table 10, it can be seen that pure c-axis orientation film that has smooth surface and shows superconducting transition temperature Tc (zero) higher than 77K can be obtained in all cases.
For the purpose of comparison, similar film forming experiment was conducted by using a target having composition of AC₂Cu₃O_{7-d}, so as to manufacture thick films (1 µm thick) having composition of AC₂Cu₃O_{7-d}, of which data are shown in Table 11.

**Table 11**

| Target constituting atoms | | | OM | Result of X-ray diffraction | Tc (zero) | Jc (at 77K) |
|---|---|---|---|---|---|---|
| A | B | C | (pieces) | (crystal orientation axis) | (K) | (MA/cm²) |
| Y | - | Ba | 11 | c | 84 | 0.64 |
| Y | - | Ba_{0.5}Sr_{0.5} | 13 | c | 82 | 0.08 |
| Gd | - | Ba | 11 | c | 83 | 0.08 |
| Yb | - | Ba | 16 | c | 81 | 0.09 |
| Note 1: Composition of the target is AC₂Cu₃O_{7-d}. | | | | | | |
| 2: OM represents the number of precipitations, bumps and dents having particular sizes located within a unit area. | | | | | | |

Comparison of the results shown in Table 10 and Table 11 shows that thick films having a composition that does not include B element (La, Nd, Sm or Eu) shows a larger number of precipitations, bumps and dents and poor smoothness with a low value of critical current density Jc, while the thick film having the composition that includes B element shows remarkable improvements in these characteristics.

### INDUSTRIAL APPLICABILITY

According to the present invention, as described above, it is made possible to provide a high temperature superconductor film having smooth surface and good superconducting characteristic that is useful for manufacturing high performance electronic devices and electric wires and can be manufactured reliably without being affected by slight changes in the film forming conditions, so that effects of very high value for the industry can be brought about such as great potential contribution to the advancements in the applied technologies of superconductor.

## Claims

1. A high temperature superconductor film having a smooth surface constituted from A, B, C, Cu and oxygen and has composition is represented by the chemical formula AₓB₍₃₋ₓ₋ _{y)}C_{y}Cu_{z}O_{7-d}, wherein x ≦ 0.99, y ≦ 1.99, 2.60 ≦ (x + y) ≦ 2.98, 2.70 ≦ z ≦ 3.30 and (7-d) is a value that satisfies the requirement of valence, when one or more elements selected from the group of Gd, Dy, Ho, Er, Tm, Yb, Lu and Y is represented by A, one or more element selected from the group of La, Nd, Sm and Eu is represented by B, and Ba₁₋ₛSrₛ (where 0 ≦ s ≦ 0.50) is represented by C.

2. The high temperature superconductor film having a smooth surface according to claim 1, wherein the number of precipitations, bumps and dents having sizes that could not be contained within an area of 1 µm square is 10 or less that are observed in an area of 30 µm square on the surface of the high temperature superconductor film when observed under an optical microscope at a magnification of 1000 times.

3. The high temperature superconductor film having a smooth surface according to claim 1, wherein the number of precipitations, bumps and dents having sizes that could not be contained within an area of 1 µm square is 5 or less that are observed in an area of 30 µm square on the surface of the high temperature superconductor film when observed under an optical microscope at a magnification of 1000 times.
